# EUROPEAN PATENT SPECIFICATION

(11) **EP 4 168 823 B1**
(45) Date of publication and mention of the grant of the patent: **19.11.2025**
(21) Application number: 21732047.2
(22) Date of filing: 11.06.2021
(51) Int. Cl.: G01S 7/481, G01S 17/04, G02B 19/00, H03K 17/94, H10F 39/12, H10F 39/00, G02B 5/02, H10K 102/00

(54) **AN APPARATUS FOR A DISPLAY**
VORRICHTUNG FÜR EINE ANZEIGE
APPAREIL D'AFFICHAGE

(30) Priority: 19.06.2020 EP 20181209
(43) Date of publication of application: 26.04.2023
(73) Proprietor: AMS-OSRAM AG, 8141 Premstätten (AT)
(72) Inventor: MANNINGER, Mario, 5656 AE Eindhoven (NL); GEIGER, Jens, 5656 AE Eindhoven (NL); SCHMIDEGG, Klaus, 5656 AE Eindhoven (NL); NEVOU, Laurent, 5656 AE Eindhoven (NL); NIKETIC, Nemanja, 5656 AE Eindhoven (NL); GUREVICH, Igor, 5656 AE Eindhoven (NL); HALLAL, Bassam, 5656 AE Eindhoven (NL)
(74) Representative: Epping - Hermann - Fischer
(86) International application number: PCT/EP2021/065858
(87) International publication number: WO 2021/254916

(56) References cited:
- WO-A1-2020/157230
- CN-A- 111 837 135
- US-A1- 2018 129 328
- US-A1- 2018 173 343
- US-A1- 2019 266 376

## Description

### FIELD OF THE DISCLOSURE

This disclosure relates to optical sensing systems which are disposed behind a display screen.

This patent application claims the priority of European patent application 20181209.6.

### BACKGROUND

Optical sensors, e.g. proximity sensors, biosensors, 3D sensors, when used behind a display, such as OLED, µLED, TFT or plasma, can cause display distortion. Optical proximity sensing typically relies on emitting infrared (IR) or near infra-red (NIR) light and measuring the light energy reflected back from the object to be detected. Oftenthe light, such as IR or NIR, has an energy that exceeds the bandgap of many semiconductors used in the display, e.g. a Si-TFT. Due to the low transmissivity of the displays, there are trade-offs between the optical power needed to achieve the required sensing distance and display distortion that is governed by the optical irradiance.

US 2018/173343 A1 discloses a fingerprint sensor device including a touch panel with an integrated touch sensor module. The integrated touch sensor module includes sensing circuitry to generate a sensor signal responsive to detecting a contact input associated with a fingerprint. The device may include a touch screen and an optical sensor module located below the touch screen to provide optical fingerprint sensing.

US 2019/266376 A1 discloses devices and optical sensor modules for provide on-screen optical sensing of fingerprints by using an under-screen optical sensor module that captures and detects light from a fiber on top of the screen. Various implementations of the under-LCD optical sensor modules are provided, including different optical imaging module designs for under-LCD optical sensing, invisible under-LCD optical sensor modules based on concealing optical transmissive features or regions under the LCD opaque borders and optical sensing of topographical features associated with inner tissues of a finger.

It is an object of the presented disclosure to provide an apparatus which overcomes the aforementioned shortcomings.

This objective is achieved by the subject-matter of the independent claims. Further developments and embodiments are described in the dependent claims.

The invention is defined in the claims. In the following, parts of the description and drawings referring to embodiments which are not covered by the claims are not presented as embodiments of the invention, but as examples useful for understanding the invention.

It is to be understood that any feature described in relation to any one embodiment may be used alone, or in combination with other features described herein, and may also be used in combination with one or more features of any other of the embodiments, or any combination of any other of the embodiments unless described as an alternative. Furthermore, equivalents and modifications not described below may also be employed without departing from the scope of the apparatus which is defined in the accompanying claims.

### SUMMARY

The present disclosure describes techniques for helping reduce or eliminate display screen distortion caused by energy from the light emitters in an optical sensor, such as a proximity sensor module, biosensor, 3D sensor, or the like. The following relates to an improved concept in the field of optical sensing systems. It is proposed to reduce a power density on the display, but increase overall emitted optical power. Optionally, a beam divergence can be tuned. One or more of the following aspects may contribute to the improved concept:
- increase package height to increase beam diameter, e.g. by using crosstalk blocking aperture,
- increase beam diameter, e.g. by using of a beam shaping optics with or without increase of package height, for example, with 2 or more lenses, a micro-lens array and collimating lens, and/or a light emitter, such as a VCSEL, with large field of illumination, FOI, plus collimating lens,
- tune the beam divergence, e.g. to reduce cross talk into the light sensor.

In this context, it has been found that in order to widen the beam diameter at the output side, e.g. an aperture of the module or optical package facing a target, a beam divergence may be increased close to the light emitter. While the beam divergence can be controlled by the emitter design this may require severe structural changes, e.g. in the epi which typically is a rather lengthy and complicated process. Instead a reducer is integrated into the module to increase beam divergence and, thus, a beam diameter at the display screen. Generally, the reducer is arranged for reducing the optical power density by increasing a diameter of the light beam generated by the light emitter, e.g. on the display screen.

In accordance with the claimed invention, the disclosure describes an apparatus that comprises a display screen, and an optical proximity sensor module disposed behind the display screen. The optical sensor module further comprises a light emitter which is operable to produce light having a wavelength for transmission through the display screen toward a target object. A light sensor is operable to sense light reflected by the target object and having the wavelength.

The optical sensor module also includes a reducer for reducing the optical power density by increasing a diameter of a light beam generated by the light emitter on the display screen. The reducer is disposed between the light emitter and the display screen so as to intersect the light beam produced by the light emitter.

The improved concept allows for implementing an optical sensor behind a display screen with largely reduced or virtually no distortion, e.g. an optical proximity sensor with a detection distance of >30 mm. The improved concept may be applied to all types of optical sensors including a light emitter, such as a proximity sensor module, biosensor, 3D sensor, or the like.

Light hereinafter denotes electromagnetic radiation within the portion of the electromagnetic spectrum that can be perceived by the human eye. This includes visible light having wavelengths in the range of 400 to 700 nanometers. However, the term "light" also includes the infrared, e.g. near infrared (with longer wavelengths) and the ultraviolet (with shorter wavelengths).

An objective can be a single lens or mirror, or combinations of several optical elements. An element which forms a beam diameter and/or divergence is considered a beam shaping optics. This includes a lens, such as a collimating lens, a group of groups of such lenses and/or an optical surface or surfaces having lens property.

The term "disposed behind the display screen" denotes that the display screen covers the optical sensor module, e.g. in a top view, viewed along a main direction of display emission, such as a surface normal of the display screen. In any case the optical sensor module is "disposed behind the display screen" so that the light beam generated by the light emitter needs to traverse through the display screen, thereby being a potential source of screen distortions.

The reducer hereinafter denotes any means which can be disposed between the light emitter and the display screen so as to intersect the light beam produced by the light emitter. This may be part of the module, such as an optical package or an optical element, such as a beam shaping optics. For example, the reducer is arranged to spread out optical energy from the light beam generated by the light emitter, thereby reducing distortion of the display screen.

Some implementations include one or more of the following features. For example, in some instances, the optical sensor module, e.g. an optical proximity sensor module is disposed behind the display with an optical barrier between light emitter and light sensor. A distance between an active surface of the light emitter and a top surface of the module, e.g. an optical package is greater than 2 mm.

In accordance with the claimed invention, the reducer comprises a beam shaping optics between the active surface of the light emitter and the top surface of the module. The beam shaping optics is operable to reduce the optical power density by increasing the beam diameter to a desired degree, i.e. to a desired beam diameter at or on the display screen.

The beam shaping optics may include various refracting and/or reflecting components such as an objective of lenses or groups of lenses and/or reflecting surfaces, such as mirrors. For example, the beam shaping optics comprises a Galilean telescope, diffusor and collimating lens, a micro-lens-array and collimating lens, a reflective beam shaper with at least two reflective surfaces and optionally one of them partially reflective.

The optical sensor module includes a light emitter which comprises one of multiple light emitting elements, each being operable to produce light transmission through the display screen toward an external target object. The light emitter, and light emitting elements may, collectively, be operable to provide sufficient optical energy for proximity sensing.

Some implementations include a VCSEL laser diode with a large field of illumination at the display screen, i.e. FOI > 30°, and a collimating lens and/or an edge emitting Laser with a beam bending facet, which creates a wide FOI vertically emitting and a collimating lens.

The following description of figures of example embodiments may further illustrate and explain aspects of the improved concept. Components and parts with the same structure and the same effect, respectively, appear with equivalent reference symbols. Insofar as components and parts correspond to one another in terms of their function in different figures, the description thereof is not necessarily repeated for each of the following figures.

### BRIEF DESCRIPTION OF DRAWINGS

- Figures 1A, 1B: show an example embodiment of an apparatus,
- Figures 2A, 2B: show another example embodiment of an apparatus,
- Figure 3: shows another example embodiment of an apparatus,
- Figure 4: shows an example power loss calculation due to the lateral offset,
- Figure 5: shows another example embodiment of a beam shaping optics,
- Figure 6: shows an example simulation, and
- Figure 7: shows an example embodiment of a beam shaping optics with reflective collimating beam expander.

### DETAILED DESCRIPTION

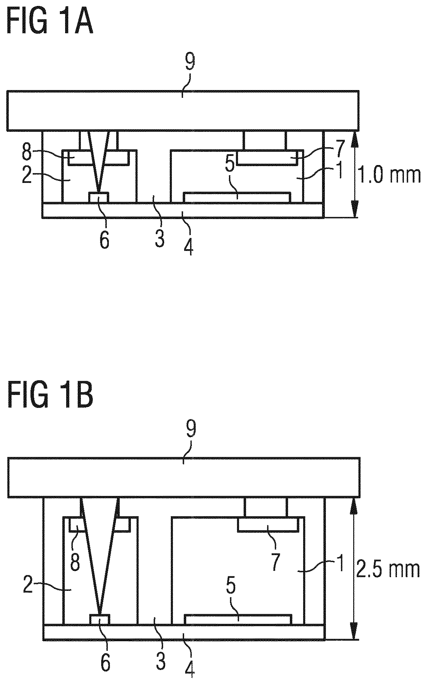

Figures 1A and 1B show an example embodiment of an apparatus. In this embodiment the apparatus comprises an optical package. The optical package comprises a two chambers 1, 2, which are optically separated by a light barrier 3, and arranged on a substrate 4. One chamber holds a receiver 5 with light sensor and the other chamber holds a light emitter 6. Both chambers can be complemented with optics 7, 8 to alter beams of light in emission and/or detection. The optical package is arranged with respect to a display 9.

Figure 1A shows a standard optical package which has 1mm height or less, as indicated by the arrow. Considering a VCSEL with a field of interest, FOI, of 20°, the light beam diameter on the display screen is about 200 µm. This may lead to distortions of the display where the beam hits the display screen. Figure 1B shows an example of the proposed optical package with increased height, e.g. 2.5 mm height. Considering a VCSEL as light emitter with a FOI of 20°, the light beam diameter on the display screen is about 750 µm. Thus, distortions of the display where the beam hits the display screen are reduced considerably. For example, the optical power density on display is reduced by 14x. The increased height of the package can be considered a reducer. In turn, the reducer has the effect to increase optical package height.

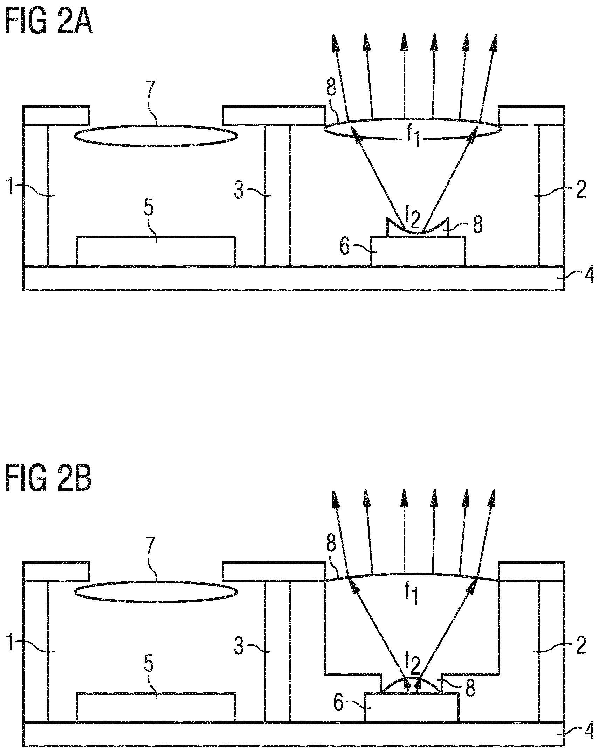

Figure 2A and 2B shows another example embodiment of an apparatus. This embodiment comprises an optical package similar to the one discussed in Figures 1A and 1B.

Alternatively, or in addition to setting the height of the package, it is proposed to alter beam diameters with beam shaping optics 8. The rationale is as follows. To widen the beam diameter at the output, the beam divergence may need to be increased close to the light emitter 6, e.g. VCSEL. The beam divergence can be controlled by the emitter design, but typically requires to change the epi, for example, which is a rather lengthy and complicated process. It is therefore preferred to use a concave lens to increase the divergence, e.g. disposed between the light emitter and the display screen so as to intersect the light beam generated by the light emitter.

A simplified model may assume a Galilean telescope. Furthermore, consider one convex lens with a focal length f1 and one concave lens with focal length f2, both focal points may coincide. Then, a beam radius magnification follows as m = f1/f2. Example: f1 = 1 mm, f2 = 0.2 mm, m = 5, total length = 0.8 mm.

In one implementation option (Figure 2A), the convex lens is arranged in the lid of the optical package, the concave lens is replicated onto the light emitter, e.g. VCSEL. This may have only small impact on the overall packaging concept since the second lens can be considered part of the light emitter, e.g. VCSEL. In another implementation option (Figure 2B) a single optical element with one convex and one concave surface is attached to a lid or aperture of the optical package. This may improve centering of the two lenses and may reduce pointing error.

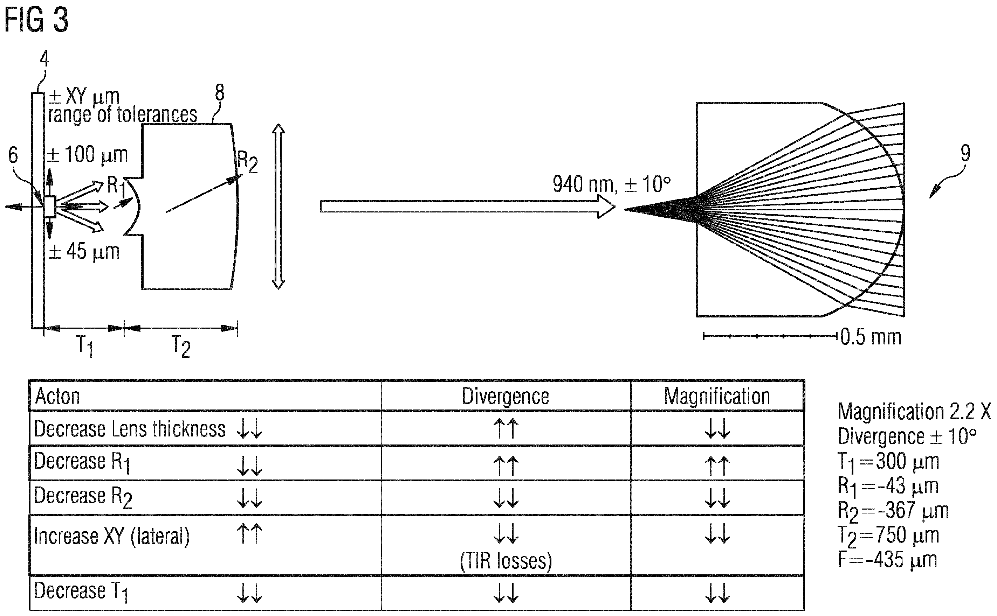

Figure 3 shows another example embodiment of an apparatus. This drawing shows an example in actual numbers and illustrates the effect that the reducer increases beam diameter with beam shaping optics. The example assumes a VCSEL emitting at 940 nm, with divergence of ±12.5°. The beam shaping optics 8, as reducer, has an inner lens radius R₁ and an outer lens radius R₂. The distance between the emitter 6 to the inner lens of radius R₁ is denoted T₁ and the lens height denoted T₂. D = 800 µm is assumed to be the beam diameter at the display screen. Further design constraints and tolerances are indicated in the drawing.

In this example, the beam diameter is expanded 3x, while keeping constant beam divergence. In principle, it is feasible to design a system that would expand the VCSEL beam (indicated in the table by double arrows pointing upwards). One issue may be that the design is stable for the given range of tolerances (indicated in the table by double arrows pointing downwards).

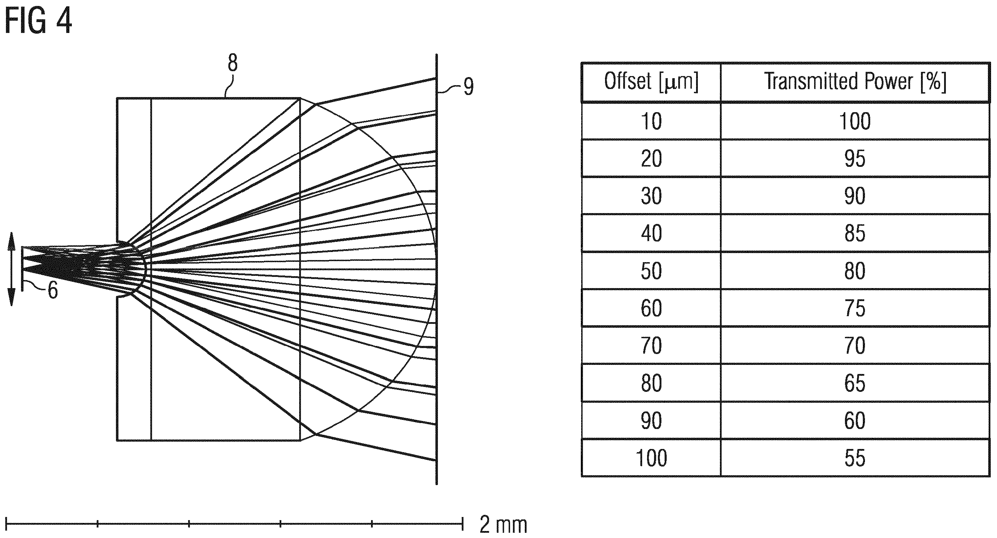

Figure 4 shows an example power loss calculation due to the lateral offset. The embodiment of Figure 3 may be prone to power loss due to the lens diameter and relative offset thereto. The drawings indicate a beam shaping optics 8, e.g. objective, and different lateral offsets of the light emitter 6. The table shows the transmitted power in % as a function of offset (in µm). Within the studied range of 100 µm offset, the transmitted power may nearly decrease by 50 %.

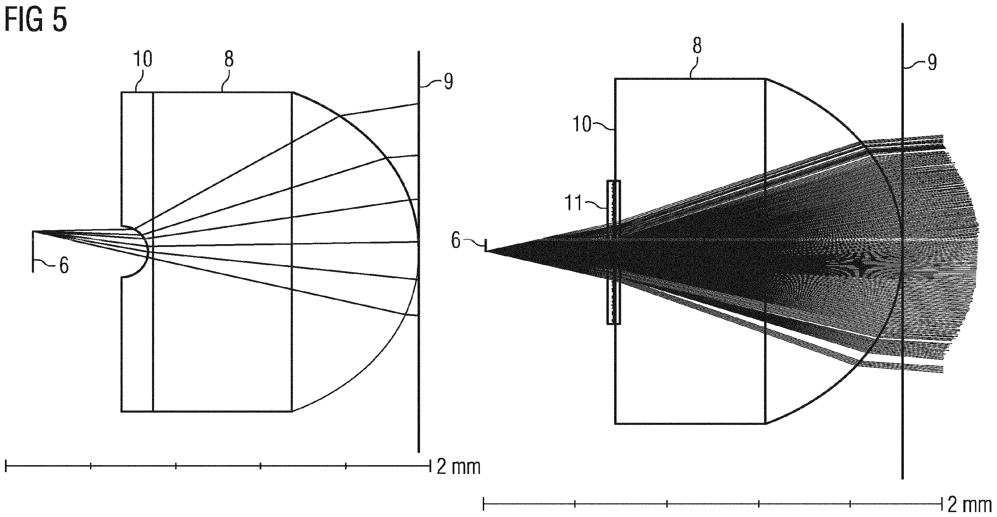

Figure 5 shows another example embodiment of a beam shaping optics. Here, a diffuser instead of the first surface. The left drawing depicts how a lens design may be prone to offset, as discussed above in Figure 4. The first surface of the lens 10, i.e. the one facing the emitter 6, receives light emitted by the emitter. As the light emitter may have an offset (as indicated in the drawing), the transmitted power may be affected or reduced. The first surface of the lens has no diffuser in this example. The right drawing depicts a first surface 10 which is arranged with a diffuser 11 (e.g., diffuser at an entrance of objective), the rest of the geometry is kept. Despite offset the transmitted power may be increased considerably.

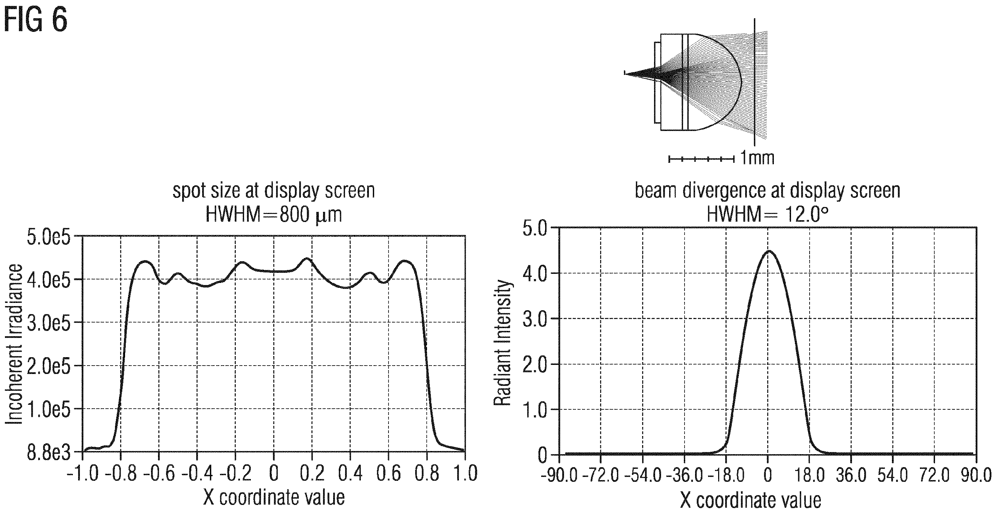

Figure 6 shows an example simulation. The diffuser introduced in Figure 5 reduces power loss due to the lateral offset. This can be simulated as depicted in the drawings. The graph on the left hand side assumed incoherent irradiation and a spot size at the display screen of HWHM = 800 µm. On the right hand side the beam divergence at the display screen has been determined. Over a range of lateral offset of 100 µm and at HWHM = 12° there is only a power loss of 0.5 % in the lateral direction.

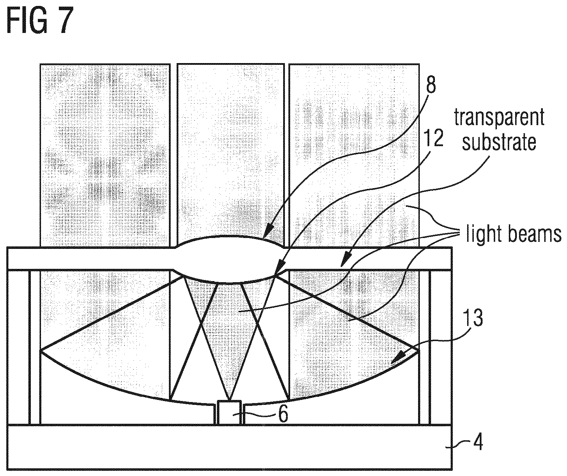

Figure 7 shows an example embodiment of a beam shaping optics with reflective collimating beam expander. The light is emitted from the light emitter LE (e.g. VCSEL). The drawing shows the chamber with the light emitter arranged on a substrate, e.g. an electronic substrate 4. The light emitter 6 is placed in a center of a reflector 13 (e.g., a mirror, lens, or lens with coating). Another reflector 12 is arranged in the lid of the optical package.

Emitted light eventually hits a first curved (convex) partial reflector 12: the larger portion of the light is reflected with higher divergence. The smaller portion is transmitted and partially collimated. The reflected light then hits the second curved (concave) reflector 13: the light beam is collimated and sent towards the exit of the package, e.g. aperture in optical package. The light from the second reflector passes the transparent substrate that carries the central reflector. The light that passed the first reflector exits the transparent material through a surface that can optionally be curved (e.g. as lens or lens surface). This lens can serve to fine adjust the divergence of the central portion of the beam. Benefits of this design include longer focal length in given z-height, thus, larger beam, and optionally better collimation

Further aspects, features and advantages will be readily apparent from the following detailed description, the accompanying drawings, and the claims.

Although this description of the improved concept contains many specifics, these should not be interpreted as limitations on the scope of the concept or what has or can be claimed, but rather as descriptions of features specific to certain embodiments of the invention. Certain features described in this disclosure in connection with separate embodiments may also be implemented in combination in a single embodiment. On the other hand, various features described in connection with a single embodiment can also be implemented in several embodiments separately or in any suitable sub-combination. In addition, although features may be described above as acting in certain combinations and even originally claimed as such, in some cases one or more features may be excised of a claimed combination, and the claimed combination may be directed to a sub-combination or variation of a sub-combination.

Accordingly, even if the operations in the drawings are presented in a specific order, this should not be understood to mean that these operations must be performed in the order shown or in sequential order, or that all the operations shown must be performed to achieve the desired results. Under certain circumstances, multitasking and parallel processing may be advantageous.

A number of implementations were described. Nevertheless, various modifications can be made without deviating from the scope of the invention, which is defined in the accompanying claims.

## Claims

1. An apparatus comprising:
- a display screen (9), and
- an optical sensor module disposed behind the display screen (9); the optical sensor module comprising:
- a light emitter (6) operable to generate light having a wavelength for transmission through the display screen (9) toward a target object,
- a light sensor (5) operable to sense light reflected by the target object and having the wavelength, and
- a reducer (8) for reducing the optical power density by increasing a diameter of a light beam generated by the light emitter on the display screen (9), wherein the reducer is disposed between the light emitter and the display screen so as to intersect the light beam generated by the light emitter, and
wherein the reducer comprises a beam shaping optics which is arranged to increase the beam diameter to a desired degree, **characterised in that**:
- the beam shaping optics comprises an objective, which, at least partly, is arranged on an active surface of the light emitter, and/or
- the reducer (8) comprises an optical package with the light emitter (6) and the light sensor (5) arranged inside the optical package, and the beam shaping optics is arranged in an aperture of the optical package facing the display screen, and/or
- the beam shaping optics comprises an optical telescope, in particular, a refracting optical telescope, such as a Galilean telescope and/or a reflecting optical telescope comprising one or more reflecting optical surfaces, and/or
- the beam shaping optics comprises a micro-lens array, and further comprises at least one collimating lens and/or collimating optical surface, and/or
- the beam shaping optics comprises at least a first and a second reflecting optical surface, which, at least in part, are operable to reflect light having the wavelength for transmission through the display screen.

2. The apparatus according to claim 1, wherein the reducer comprises the optical package with the light emitter and the light sensor arranged inside the optical package, and the optical package has a height which is arranged to increase the beam diameter to the desired degree.

3. The apparatus according to claim 2, wherein the height of the optical package is larger than 1 mm, in particular larger than 2 mm.

4. The apparatus according to claim 2 or 3, wherein the height of the optical package is defined between a top surface and bottom surface, wherein the light emitter and the light sensor are arranged on the bottom surface and the top surface faces the display screen.

5. The apparatus according to one of claims 1 to 4, wherein the beam shaping optics comprises the at least one collimating lens and/or collimating optical surface.

6. The apparatus according to one of claims 1 to 5, wherein the beam shaping optics comprises a diffusor and the at least one collimating lens and/or collimating optical surface.

7. The apparatus according to one of claims 1 to 6, wherein the reducer (8) comprises the optical package with the light emitter (6) and the light sensor (5) arranged inside the optical package, and a center optical axis of the beam shaping optics is offset with respect to an optical axis of the optical package, in particular, offset with respect to the optical axis defined by a main direction of emission of the light emitter.

8. The apparatus according to one of claims 1 to 7, wherein the light emitter comprises one or more light emitting elements, wherein the light emitting elements are of resonant-cavity type, such as at least one of:
- a vertical-cavity surface-emitting laser, VCSEL,
- an edge emitting laser with beam bending facet,
- a micro-disk laser,
- a resonant cavity light emitting diode, and/or
- a distributed feedback laser, DFB.

9. The apparatus according to one of claims 1 to 8, wherein the display screen is an OLED, micro-LED, TFT, or plasma display screen.

## Patentansprüche

1. Vorrichtung, umfassend:
- einen Anzeigebildschirm (9) und
- ein hinter dem Anzeigebildschirm (9) angeordnetes optisches Sensormodul; wobei das optische Sensormodul ferner umfasst:
- einen Lichtemitter (6), der so betrieben werden kann, dass er Licht mit einer Wellenlänge erzeugt, das durch den Anzeigebildschirm (9) hindurch zu einem Zielobjekt übertragen wird,
- einen Lichtsensor (5), der so betrieben werden kann, dass er das vom Zielobjekt reflektierte Licht mit der Wellenlänge erfasst, und
- einen Reduzierer (8) zum Verringern der optischen Leistungsdichte durch Vergrößern des Durchmessers eines vom Lichtemitter erzeugten Lichtstrahls auf dem Bildschirm (9), wobei der Reduzierer zwischen dem Lichtemitter und dem Anzeigebildschirm angeordnet ist, um den vom Lichtemitter erzeugten Lichtstrahl zu schneiden, und wobei der Reduzierer eine Strahlformungsoptik umfasst, die so ausgelegt ist, dass sie den Strahldurchmesser auf ein gewünschtes Maß vergrößert,
**dadurch gekennzeichnet dass**:
- die Strahlformungsoptik ein Objektiv umfasst, das zumindest teilweise auf einer aktiven Oberfläche des Lichtemitters angeordnet ist, und/oder
- der Reduzierer (8) ein optisches Gehäuse umfasst , in dem der Lichtemitter (6) und der Lichtsensor (5) angeordnet sind, und die Strahlformungsoptik in einer Öffnung des optischen Gehäuses angeordnet ist, die dem Bildschirm zugewandt ist, und/oder
- die Strahlformungsoptik ein optisches Teleskop umfasst, insbesondere ein refraktives optisches Teleskop, wie beispielsweise ein Galileisches Teleskop, und/oder ein reflektierendes optisches Teleskop, das eine oder mehrere reflektierende optische Oberflächen umfasst, und/oder
- die Strahlformungsoptik ein Mikrolinsen-Array umfasst und ferner mindestens eine Kollimatorlinse und/oder eine kollimierende optische Oberfläche umfasst, und/oder
- die Strahlformungsoptik mindestens eine erste und eine zweite reflektierende optische Oberfläche umfasst, die zumindest teilweise dazu eingerichtet sind, Licht mit der Wellenlänge für die Transmission durch den Bildschirm zu reflektieren.

2. Vorrichtung nach Anspruch 1, wobei der Reduzierer das optische Gehäuse mit dem Lichtemitter und dem Lichtsensor umfasst, die innerhalb des optischen Gehäuses angeordnet sind, und das optische Gehäuse eine Höhe aufweist, die so ausgelegt ist, dass sie den Strahldurchmesser auf das gewünschte Maß vergrößert.

3. Vorrichtung nach Anspruch 2, wobei die Höhe des optischen Gehäuses größer als 1 mm, insbesondere größer als 2 mm ist.

4. Vorrichtung nach Anspruch 2 oder 3, wobei die Höhe des optischen Gehäuses zwischen einer Oberseite und einer Unterseite definiert ist, wobei der Lichtemitter und der Lichtsensor auf der Unterseite angeordnet sind und die Oberseite dem Bildschirm zugewandt ist.

5. Vorrichtung nach einem der Ansprüche 1 bis 4, wobei die Strahlformungsoptik mindestens eine Kollimatorlinse und/oder eine kollimierende optische Fläche umfasst.

6. Vorrichtung nach einem der Ansprüche 1 bis 5, wobei die Strahlformungsoptik einen Diffusor und die mindestens eine Kollimatorlinse und/oder kollimierende optische Fläche umfasst.

7. Vorrichtung nach einem der Ansprüche 1 bis 6, wobei der Reduzierer (8) das optische Gehäuse mit dem Lichtemitter (6) und dem Lichtsensor (5), die innerhalb des optischen Gehäuses angeordnet sind, umfasst und eine mittlere optische Achse der Strahlformungsoptik gegenüber einer optischen Achse des optischen Gehäuses versetzt ist, insbesondere gegenüber der optischen Achse, die durch eine Hauptemissionsrichtung des Lichtemitters definiert ist.

8. Vorrichtung nach einem der Ansprüche 1 bis 7, wobei der Lichtemitter ein oder mehrere lichtemittierende Elemente umfasst, wobei die lichtemittierenden Elemente vom Resonanzhohlraumtyp sind, wie beispielsweise mindestens eines der folgenden:
- einem Vertical-Cavity Surface-Emitting Laser (VCSEL),
- einem kantenemittierenden Laser mi Strahlablenkungsfacette,
- einem Mikroscheibenlaser,
- einer Resonanzhohlraum-Leuchtdiode und/oder
- einem Distributed-Feedback-Laser (DFB).

9. Vorrichtung nach einem der Ansprüche 1 bis 8, wobei der Bildschirm ein OLED-, Mikro-LED-, TFT- oder Plasmabildschirm ist.

## Revendications

1. Appareil comprenant:
- un écran d'affichage (9), et
- un module de capteur optique disposé derrière l'écran d'affichage (9); le module de capteur optique comprenant:
- un émetteur de lumière (6) pouvant fonctionner pour générer une lumière ayant une longueur d'onde pour être transmise à travers l'écran d'affichage (9) vers un objet cible,
- un capteur de lumière (5) pouvant fonctionner pour détecter la lumière réfléchie par l'objet cible et ayant la longueur d'onde, et
- un réducteur (8) destiné à réduire la densité de puissance optique en augmentant le diamètre d'un faisceau lumineux généré par l'émetteur de lumière sur l'écran d'affichage (9), dans lequel le réducteur est disposé entre l'émetteur de lumière et l'écran d'affichage de manière à intersecter le faisceau lumineux généré par l'émetteur de lumière, et
dans lequel le réducteur comprend une optique de mise en forme du faisceau qui est agencée pour augmenter le diamètre du faisceau à un degré souhaité, **caractérisé en ce que** :
- l'optique de mise en forme du faisceau comprend un objectif qui est, au moins en partie, disposé sur une surface active de l'émetteur de lumière, et/ou
- le réducteur (8) comprend un boîtier optique avec l'émetteur de lumière (6) et le capteur de lumière (5) disposés à l'intérieur du boîtier optique, et l'optique de mise en forme du faisceau est disposée dans une ouverture du boîtier optique faisant face à l'écran d'affichage, et/ou
- l'optique de mise en forme du faisceau comprend un télescope optique, en particulier un télescope optique réfracteur, tel qu'un télescope galiléen, et/ou un télescope optique réflecteur comprenant une ou plusieurs surfaces optiques réfléchissantes, et/ou
- l'optique de mise en forme du faisceau comprend un réseau de microlentilles et comprend en outre au moins une lentille de collimation et/ou une surface optique de collimation, et/ou
- l'optique de mise en forme du faisceau comprend au moins une première et une deuxième surfaces optiques réfléchissantes qui, au moins en partie, sont aptes à réfléchir la lumière ayant la longueur d'onde pour la transmission à travers l'écran d'affichage.

2. Appareil selon la revendication 1, dans lequel le réducteur comprend le boîtier optique avec l'émetteur de lumière et le capteur de lumière disposés à l'intérieur du boîtier optique, et le boîtier optique a une hauteur qui est disposée pour augmenter le diamètre du faisceau au degré souhaité.

3. Appareil selon la revendication 2, dans lequel la hauteur du boîtier optique est supérieure à 1 mm, en particulier supérieure à 2 mm.

4. Appareil selon la revendication 2 ou 3, dans lequel la hauteur du boîtier optique est définie entre une surface supérieure et une surface inférieure, dans lequel l'émetteur de lumière et le capteur de lumière sont disposés sur la surface inférieure et la surface supérieure fait face à l'écran d'affichage.

5. Appareil selon l'une des revendications 1 à 4, dans lequel l'optique de mise en forme du faisceau comprend au moins une lentille de collimation et/ou une surface optique de collimation.

6. Appareil selon l'une des revendications 1 à 5, dans lequel l'optique de mise en forme du faisceau comprend un diffuseur et au moins une lentille de collimation et/ou une surface optique de collimation.

7. Appareil selon l'une des revendications 1 à 6, dans lequel le réducteur (8) comprend le boîtier optique avec l'émetteur de lumière (6) et le capteur de lumière (5) disposés à l'intérieur du boîtier optique, et un axe optique central de l'optique de mise en forme du faisceau est décalé par rapport à un axe optique du boîtier optique, en particulier décalé par rapport à l'axe optique défini par une direction principale d'émission de l'émetteur de lumière.

8. Appareil selon l'une des revendications 1 à 7, dans lequel l'émetteur de lumière comprend un ou plusieurs éléments émetteurs de lumière, dans lequel les éléments émetteurs de lumière sont du type à cavité résonnante, tels qu'au moins l'un des éléments suivants:
- un laser à cavité verticale à émission par la surface, VCSEL,
- un laser à émission latérale avec facette de courbure du faisceau,
- un laser à microdisque,
- une diode électroluminescente à cavité résonnante, et/ou
- un laser à rétroaction distribuée, DFB.

9. Appareil selon l'une des revendications 1 à 8, dans lequel l'écran d'affichage est un OLED, micro-LED, TFT ou écran d'affichage plasma.
